# EUROPEAN PATENT APPLICATION

(11) **EP 2 566 038 A1**
(43) Date of publication of application: **06.03.2013**
(21) Application number: 11775093.5
(22) Date of filing: 28.04.2011
(51) Int. Cl.: H02N 2/00

(54) **VIBRATION POWER GENERATION DEVICE AND METHOD FOR MANUFACTURING SAME**

(30) Priority: 28.04.2010 JP 2010104269
(71) Applicant: Panasonic Corporation, Kadoma-shi Osaka 571-8501 (JP)
(72) Inventor: OGAWA, Junya, Osaka 540-6207 (JP); YAMAUCHI, Norihiro, Osaka 540-6207 (JP); MATSUSHIMA, Tomoaki, Osaka 540-6207 (JP); AIZAWA, Koichi, Osaka 540-6207 (JP)
(74) Representative: Appelt, Christian W.
(86) International application number: PCT/JP2011/060346
(87) International publication number: WO 2011/136312

(57) **Abstract**

Disclosed is a vibration power generation device which is provided with: a frame section; a weight section provided inside the frame section; a flexure section that is joined between the frame section and the weight section and is configured to bend in response to a displacement of the weight section; and a power generation section that is located at least at the flexure section and configured to generate an alternating-current voltage in response to a vibration of the weight section. The frame section and the weight section are formed of a silicon substrate. The power generation section comprises, at its own surface, an elastic film formed of a resin material. The flexure section comprises the elastic film formed of the resin material having a Young's modulus smaller than that of silicon forming the frame section and the weight section.

## Description

### Technical Field

The invention relates to a vibration power generation device configured to covert vibration energy into electric energy through the MEMS (micro electro mechanical systems) technology, and a method of making the same.

### Background Art

There is an existing power-generating device that is a sort of MEMS device for converting vibration energy, derived from vibration such as movement of cars or persons, into electric energy. Such power-generating devices have been studied (e.g., R. van Schai jk, et al, "Piezoelectric ALN energy harvesters for wireless autonomous transducer solution", IEEE SENSORS 2008 Conference, 2008, p. 45-48 (hereinafter referred to as a "document 1")).

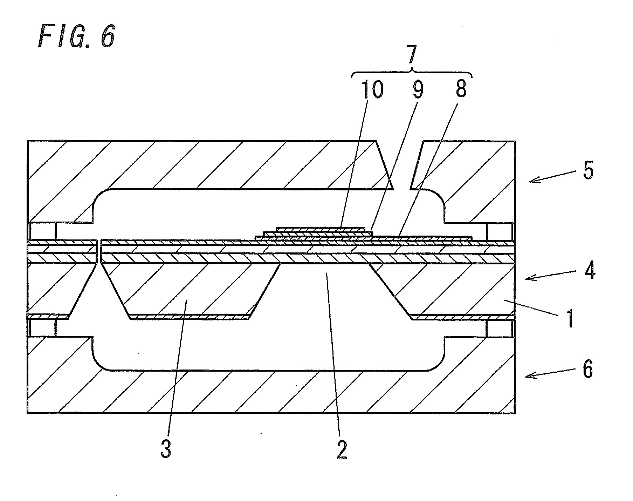

As shown in FIG. 6, the power-generating device described in the document 1 includes a main substrate 4, a first cover substrate 5 and a second cover substrate 6. The main substrate 4 has a frame section 1, and a weight section 3 that is swingably supported through a flexible flexure section 2 inside the frame section 1, and is formed of a substrate for element formation. The first cover substrate 5 is formed of a substrate for first cover formation, and the frame section 1 is stuck to a side of one surface of the main substrate 4. The second cover substrate 6 is formed of a substrate for second cover formation, and the frame section 1 is stuck to a side of other surface of the main substrate 4. A power generation section 7 for generating an alternating-current voltage in response to a vibration of the weight section 3 is formed at the flexure section 2 of the main substrate 4. The power generation section 7 also has a laminate structure of a lower electrode 8, a piezoelectric layer 9 and an upper electrode 10.

There is however a problem that an output of such a monolithic power-generating device is small. Because a silicon density of the weight section 3 is comparatively smaller than that of a metallic material, and a silicon Young's modulus of the weight section 3 is larger than that of the metallic material, and accordingly the weight section 3 does not vibrate sufficiently in response to an external vibration.

### Summary of Invention

The present invention is provided in view of the aforementioned background art, and an object is to provide a vibration power generation device capable of effectively transmitting an external vibration to a weight section, and a method of making the same.

In order to solve the aforementioned problem, a vibration power generation device of the present invention comprises: a frame section; a weight section located inside the frame section; a flexure section that is joined between the frame section and the weight section and is configured to bend in response to a displacement of the weight section; and a power generation section that is located at least at the flexure section and configured to generate an alternating-current voltage in response to a vibration of the weight section. The frame section and the weight section are formed of a silicon substrate. The power generation section comprises, at its own surface, an elastic film formed of a resin material. The flexure section comprises the elastic film formed of the resin material having a Young's modulus smaller than that of silicon forming the frame section and the weight section. Preferably, the flexure section consists of at least only the elastic film of the elastic film, and an etching stop layer with respect to the silicon substrate, and is provided with the power generation section.

In the vibration power generation device, it is preferable that the elastic film is formed and extended up to the weight section.

In a method of making a vibration power generation device, it is preferable that the frame section and the weight section are formed of a silicon substrate formed with an etching stop layer, and the flexure section is formed by etching the silicon substrate up to reaching the etching stop layer.

In the vibration power generation device of the present invention, the flexure section comprises the elastic film formed of the resin material having a Young's modulus smaller than that of the silicon forming the frame section and the weight section. Thereby, the power generation section can obtain a large output in response to an external vibration having a comparatively low accelerated velocity, and can also prevent, through the elastic film, breakages of the flexure section due to a vibration of the weight section.

### Brief Description of Drawings

Preferred embodiments of the invention will now be described in further details. Other features and advantages of the present invention will become better understood with regard to the following detailed description and accompanying drawings where:
FIG. 1 is a schematic exploded perspective view of a vibration power generation device in accordance with an embodiment of the present invention;
FIG. 2 is a schematic plan of a silicon substrate's region of the vibration power generation device in accordance with the embodiment of the present invention;
FIG. 3A is a sectional view of a silicon substrate's region taken along line A-A' of FIG. 2 and a schematic plan of an elastic film's region of a vibration power generation device in accordance with an embodiment of the present invention, and FIG. 3B is a sectional view of a modified silicon substrate's region taken along line A-A' of FIG. 2 and a schematic plan of a modified elastic film's region of a vibration power generation device in accordance with an embodiment of the present invention; and
FIG. 4 is a schematic exploded perspective view of a vibration power generation device in accordance with an embodiment of the present invention;
FIG. 5 shows sectional views in A-A' of FIG. 2 for explaining principal processes in a method of making of a silicon substrate region of a vibration power generation device in accordance with an embodiment of the present invention; and
FIG. 6 is a schematic sectional view of a vibration power generation device as a prior art.

### Description of Embodiments

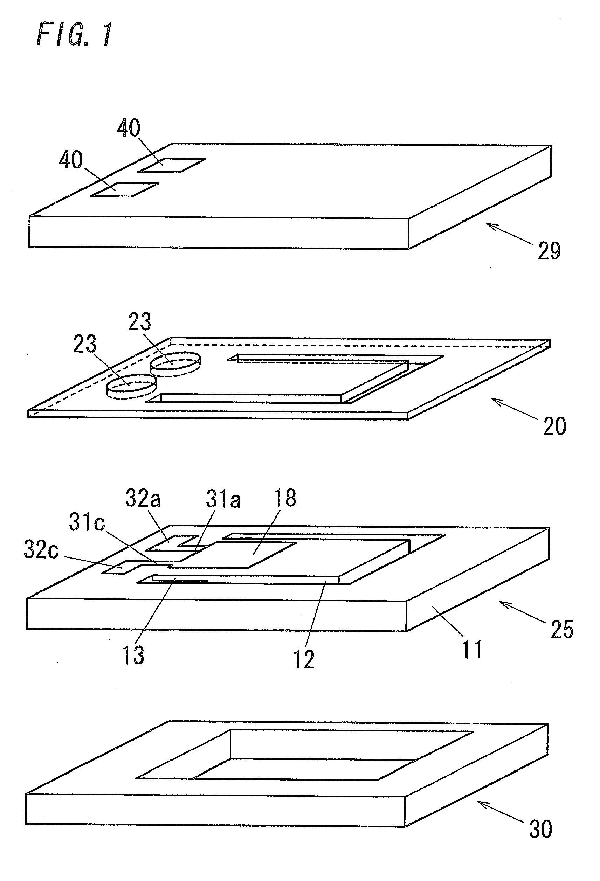

FIGS. 1-4 show a vibration power generation device in accordance with an embodiment of the present invention. The vibration power generation device includes, at least, a frame section 11, a weight section 12, a flexure section 13 and a power generation section 18. The weight section 12 is provided inside the frame section 11. The flexure section 13 is joined between the frame section 11 and the weight section 12, and is adapted to bend in response to a displacement of the weight section 12. The power generation section 18 is located at least at the flexure section 13, and is configured to generate an alternating-current voltage in response to a vibration of the weight section 12. The frame section 11 and the weight section 12 are formed of a silicon substrate. An elastic film 20 made of a resin material is formed on a surface of the power generation section 18. The flexure section 13 comprises the elastic film 20 made of a resin material having a Young's modulus smaller than that of the silicon forming the frame section 11 and the weight section 12. The elastic film 20 is also formed and extended up to the weight section 12.

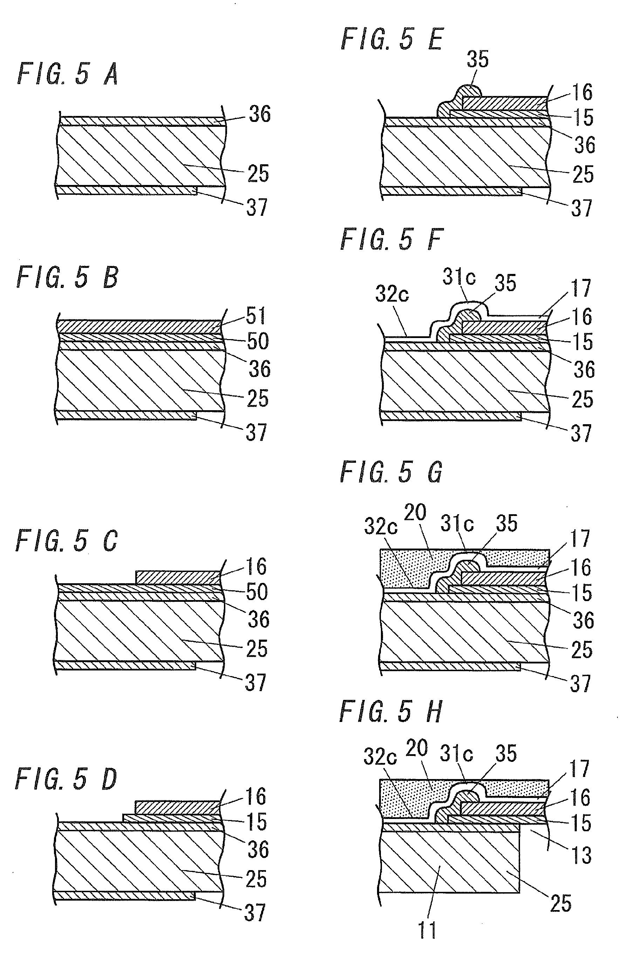

As shown in FIG. 5, in a method of making the vibration power generation device, the frame section 11 and the weight section 12 are formed of a silicon substrate 25 formed with an etching stop layer (a silicon dioxide film 36 to be described). The flexure section 13 is formed by etching the silicon substrate 25 up to reaching the etching stop layer.

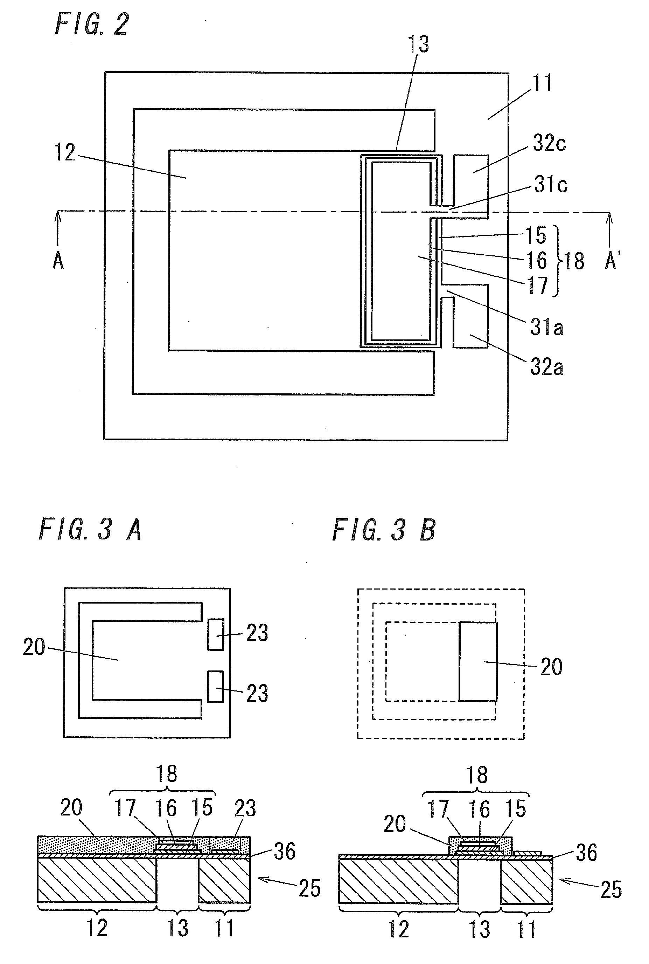

The silicon substrate 25 has first and second surfaces, and the power generation section 18 is formed on a side of the first surface. The silicon substrate 25 is provided, from the side of the first surface, with the silicon dioxide film 36, the power generation section 18, and the elastic film 20 made of a resin material having a Young's modulus smaller than that of silicon. In the embodiment, the frame section 11 and the weight section 12 are mainly formed of the silicon substrate 25, the silicon dioxide film 36 and the elastic film 20, while the flexure section 13 is mainly formed of the elastic film 20. It is preferable that each of the silicon dioxide films 36 shown in FIGS. 3A and 3B should be removed. In short, the flexure section (13) of the present invention comprises at least an elastic film (20) of the elastic film (20), and an etching stop layer with respect to a silicon substrate (25), and is provided with a power generation section (18). The flexure section of the present invention may therefore include the etching stop layer.

As shown in FIG. 1, the vibration power generation device has a first cover substrate 29 fixed to the frame section 11 in the first surface of the silicon substrate 25. The vibration power generation device also has a second cover substrate 30 fixed to the frame section 11 in the second surface at the opposite side from the first surface of the silicon substrate 25. The first and second cover substrates 29 and 30 are formed of silicon, glass or the like. Thus, in the example of FIG. 1, the vibration power generation device is formed of the silicon substrate 25, the first cover substrate 29 and the second cover substrate 30.

The vibration power generation device and the method of making the same in the embodiment are now explained in detail.

As shown in FIG. 2, an external form of the frame section 11 in a planar view is in the shape of a rectangle. An external form of the weight section 12 and the flexure section 13 in a planar view, which are formed inside the frame section 11 is also in the shape of a rectangle like the external form of the frame section 11. An external form of the power generation section 18 in a planar view, which is located at the flexure section 13 is in the shape of a rectangle along the external form of the flexure section 13. In other words, the weight section 12 includes first and second ends, and has free and supported ends at the first and second ends, respectively. The supported end is supported by a part, as a supporting section, of the frame section 11 through the flexure section 13. In the example of FIG. 3, the frame section 11 is a rectangular frame having a rectangular hole, and the weight section 12 is in the shape of a rectangular board placed inside the frame section 11. The aforementioned first and second ends correspond to both ends, in a longitudinal direction, of the weight section 12. The elastic film 20 is also formed at least between an edge of the supported end of the weight section 12 and an edge of the supporting section of the frame section 11.

The vibration power generation device comprises the power generation section 18 that is formed on a surface of the silicon dioxide film 36 formed on the side of the first surface of the silicon substrate 25. That is, a lower electrode 15, a piezoelectric layer 16 and an upper electrode 17 are stacked in order from a side of the surface of the silicon dioxide film 36, and constitute the power generation section 18. In the side of the surface of the silicon dioxide film 36, the lower and upper electrodes 15 and 17 are formed with connection lines 31a and 31c formed of metallic lines, respectively. In the side of the surface of the silicon dioxide film 36, lower and upper electrode pads 32a and 32c electrically connected through the connection lines 31a and 31c are also formed.

The power generation section 18 is designed so that a flat surface of the lower electrode 15 has the largest size, a flat surface of the piezoelectric layer 16 has a second-largest size, and a flat surface of the upper electrode 17 has the smallest size. In the embodiment, the piezoelectric layer 16 and the upper electrode 17 are located, in a planar view, inside peripheral edges of the lower electrode 15 and the piezoelectric layer 16, respectively.

As shown in FIG. 3A, the elastic film 20 may be formed of a resin material so that it covers all the side of the first surface of the silicon substrate 25. In this instance, the elastic film 20 is formed with through-holes 23 at positions corresponding to the lower and upper electrode pads 32a and 32c in order to obtain an alternating-current voltage from the pads, and metallic films are formed in the through-holes 23. PMMA (polymethacrylate methyl resin), polyimide or the like is also employed as the resin material. In addition, as shown in FIG. 3B, the elastic film 20 just has to cover at least the power generation section 18. In this instance, if the lower and upper electrode pads 32a and 32c are exposed at the surface, no through-hole 23 is required. Each form, in a planar view, of the through-holes 23 may be in the shape of a quadrangle, a circle or the like, and is not limited to this as long as the lines can be located.

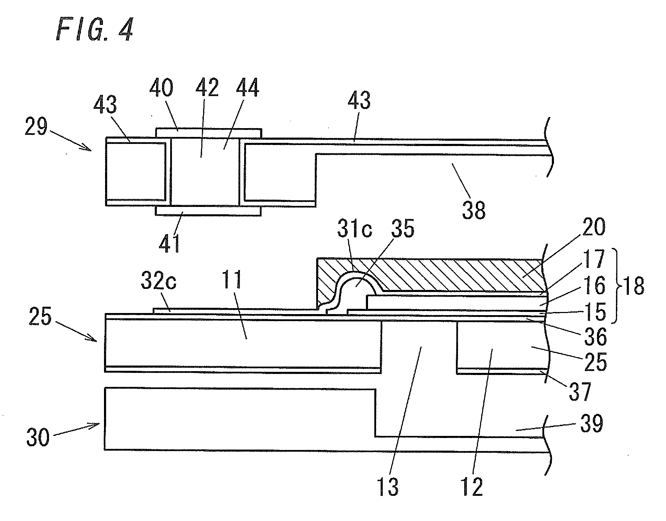

As shown in FIG. 4, the power generation section 18 is formed by stacking the lower electrode 15, the piezoelectric layer 16 and the upper electrode 17 in order from the aforementioned side of the surface of the silicon dioxide film 36. The power generation section 18 is formed at least from a boundary between the frame section 11 and the flexure section 13 up to a boundary between the weight section 12 and the flexure section 13. If the power generation section 18 is aligned at the boundary between the frame section 11 and the flexure section 13, the electric-generating capacity is improved because non-contributory part for electric generation by a vibration of the power generation section 18 does not exist.

An insulating section 35 for preventing a short between the connection line 31c electrically connected to the upper electrode 17 and the lower electrode 15 is formed at the side of the first surface of the silicon substrate 25 so that it covers ends of the lower electrode 15 and the piezoelectric layer 16 at a side of the frame section 11. The insulating section 35 is formed of a silicon dioxide film, but is not limited to the silicon dioxide film. The insulating section may be formed of a silicon nitride film. A seed layer of MgO (not shown) layer is formed between the silicon substrate 25 and the lower electrode 15. Silicon dioxide films 36 and 37 are formed on the first and second surface sides of the silicon substrate 25, respectively. In addition, in the embodiment, a substrate material of the silicon substrate 25 is silicon, and accordingly the silicon dioxide film 36 on the first surface of the silicon substrate is an etching stop layer. When the flexure section 13 is formed, all part, corresponding to the flexure section 13, of the silicon substrate is removed by etching. The wiring pattern and the power generation section 18 are formed on the silicon substrate 25, but are covered with the elastic film 20 and accordingly are not visible in a planar view. The elastic film 20 is provided with the through-holes 23 at the positions corresponding to the lower and upper electrodes 32a and 32c in order to obtain an alternating-current voltage from the pads.

The first cover substrate 29 has first and second surfaces, and the second surface of the first cover substrate 29 is joined to the side of the first surface of the silicon substrate 25. The first cover substrate is formed, at a part of the second surface in a side of the silicon substrate 25, with a displacement space as a first recess 38 of a movable portion formed of the weight section 12 and the flexure section 13.

Output electrodes 40 and 40 for supplying an alternating-current voltage generated at the power generation section 18 to the outside are formed at a side of the first surface of the first cover substrate 29. The output electrodes 40 and 40 are electrically connected to coupled electrodes 41 and 41 formed at a side of the second surface of the first cover substrate 29 through through-hole wires 42 and 42 penetrated and provided in a thickness direction of the first cover substrate 29, respectively. In this instance, the coupled electrodes 41 and 41 of the first cover substrate 29 are coupled and electrically connected to the lower and upper electrodes 32a and 32c of the silicon substrate 25, respectively. In addition, each of the output electrodes 40 and 40 and the coupled electrodes 41 and 41 is formed of a laminated film of a Ti film and an Au film, but is not limited to the material and the laminar structure in particular. In addition, Cu is employed as each material of the through-hole wires 42 and 42, but not limited to this. For example, Ni, Al or the like may be employed.

In the embodiment, when a substrate of silicon is employed as the first cover substrate 29, the first cover substrate 29 is formed, in order to prevent a short between the two output electrodes 40 and 40, so that an insulating film 43 is formed at the first and second surface sides of the first cover substrate 29 and inner circumference surfaces of through-holes 44 and 44 inside which the through-hole wires 42 and 42 are formed. In addition, when an insulating substrate such as a substrate of glass is employed as the first cover substrate 29, such an insulating film 43 is unnecessary.

The second cover substrate 30 has first and second surfaces, and the first surface of the second cover substrate 30 is joined to the side of the second surface of the silicon substrate 25. A displacement space of the movable portion formed of the weight section 12 and the flexure section 13 is formed, as a second recess 39, at a side of the first surface of the second cover substrate 30. An insulating substrate such as a glass substrate may be employed as the second cover substrate 30.

The first cover substrate 29 is joined to the silicon substrate 25 comprising the elastic film 20 by adhesive or the like. The silicon substrate 25 and the second cover substrate 30 are joined by a normal temperature joining process, but not limited to the normal temperature joining process. For example, they may be joined by an anodic bonding process, or a resin adhesion process using epoxide resin or the like. In addition, the vibration power generation device of the embodiment is formed by a manufacturing technique for MEMS devices, or the like.

In the vibration power generation device of the embodiment described above, since the power generation section 18 is formed of the lower electrode 15, the piezoelectric layer 16 and the upper electrode 17, the piezoelectric layer 16 receives a stress by a vibration of the flexure section 13, and charge bias generates in the lower and upper electrodes 15 and 17, and an alternating-current voltage is generated at the power generation section 18.

In this instance, according to a relation of P ∝ e²/ε, a generating efficiency is more increased as P becomes larger, where P, e and ε are an electric generation index, a piezoelectric constant and a relative permittivity of a piezoelectric material used for the piezoelectric layer 16 of the vibration power generation device, respectively. In consideration of general values of a piezoelectric constant e and a relative permittivity ε of each of PZT and AIN that are typical piezoelectric materials used for vibration power generation devices, the electric generation index P can be increased by employing PZT of which piezoelectric constant e is large and contributes to the electric generation index P at a square. In the vibration power generation device of the embodiment, PZT that is a type of lead-based piezoelectric material is employed as the piezoelectric material of the piezoelectric layer 16, but the embodiment is not limited to PZT. For example, PZT-PMN(:Pb(Mn, Nb)O₃) or PZT dope with other impure substance may be employed. However, the piezoelectric material of the piezoelectric layer 16 is not limited to the lead-based piezoelectric material. Other piezoelectric material may be employed.

A method of making the vibration power generation device in the embodiment is explained with reference to FIG. 5. FIGS. 5A-H show regions corresponding to the cross section taken along line A-A' in FIG. 2.

An insulating film forming process is first performed by forming silicon dioxide films 36 and 37 at first and second surface sides of a silicon substrate 25 made of silicon by a thermal oxidation method or the like, respectively, thereby obtaining the structure shown in FIG. 5A. Specifically, the (first) silicon dioxide film 36 is formed on all the first surface of the silicon substrate 25, while the (second) silicon dioxide film 37 is formed on the second surface of the silicon substrate 25 except a formation region of a flexure section 13.

A metallic layer forming process is then performed by forming a metallic layer 50 of a Pt layer on all the first surface of the silicon substrate 25 by a sputter technique, a CVD method or the like, wherein the metallic layer becomes the basis for a lower electrode 15, a connection line 31a and a lower electrode pad 32a. A piezoelectric membrane forming process is then performed by forming a piezoelectric membrane 51 (e.g., a PZT film or the like) on all the metallic layer 50 by a sputter technique, a CVD method, a sol-gel method or the like, wherein the piezoelectric membrane becomes the basis for a piezoelectric layer 16 made of a piezoelectric material (e.g., PZT or the like). Thereby, the structure shown in FIG. 5B is obtained. However, the metallic layer 50 is not limited to the Pt layer. For example, the metallic layer may be an Al layer or Al-Si layer or may be formed of a PT layer and a Ti layer, intervening between the PT layer and a seed layer, for improving adhesion. The material of the adhesion layer is not limited to Ti. The material may be Cr, Nb, Zr, TiN, TaN or the like.

After the piezoelectric membrane forming process, a piezoelectric membrane patterning process is performed by patterning the piezoelectric membrane 51 through a photolithography technique and an etching technique to form a piezoelectric layer 16 formed of a part of the piezoelectric membrane 51, thereby obtaining the structure shown in FIG. 5C.

A metallic layer patterning process is then performed by patterning the metallic layer 50 through a photolithography technique and an etching technique to form a lower electrode 15, a connection line 31a and a lower electrode pad 32a that are formed of a part of the metallic layer 50, thereby obtaining the structure shown in FIG. 5D. In the embodiment, the connection line 31a and the lower electrode pad 32a are formed along with the lower electrode 15 by patterning the metallic layer 50 in the metallic layer patterning process, but the embodiment is not limited to this. A wiring forming process for forming the connection line 31a and the lower electrode pad 32a may be further provided after only the lower electrode 15 is formed by patterning the metallic layer 50 in the metallic layer patterning process. A connection line forming process for forming the connection line 31a and a lower electrode pad forming process for forming the lower electrode pad 32a may be provided separately. In addition, the metallic layer 50 may be etched by, for example, an RIE method, an ion-milling method or the like.

After the lower electrode 15, the connection line 31a and the lower electrode pad 32a are formed by the aforementioned metallic layer patterning process, an insulating section forming process is performed by forming an insulating section 35 at the side of the first surface of the substrate 25, thereby obtaining the structure shown in FIG. 5E. In the insulating section forming process, an insulating layer is formed on all the first surface side of the substrate 25 by a CVD method or the like and then patterned through a photolithography technique and an etching technique, but the insulating section 35 may be formed through a liftoff process.

After the aforementioned insulating section forming process, an upper electrode forming process is performed by forming an upper electrode 17 through, for example, a thin-film formation technique such as an EB evaporation method, a sputter technique or a CVD method, a photolithography technique and an etching technique, while at the same time a wiring forming process is performed by forming a connection line 31c and an upper electrode pad 32c through a thin-film formation technique such as an EB evaporation method, a sputter technique or a CVD method, a photolithography technique and an etching technique, thereby obtaining the structure shown in FIG. 5F. In other words, in the embodiment, the connection line 31c and the upper electrode pad 32c are formed along with the upper electrode 17 in the upper electrode forming process, but the embodiment is not limited to this. The upper electrode forming process and the wiring forming process may be performed separately. In addition, in the wiring forming process, a connection line forming process for forming a connection line 31c and an upper electrode pad forming process for forming an upper electrode pad 32c may be performed separately. Preferably , the upper electrode 17 is etched by dry etching such as an RIE method, but wet etching may be applied. For example, an Au film and a Ti film may be wet-etched by a potassium iodide solution and a hydrogen peroxide solution, respectively. The upper electrode 17 is formed of Pt, Al, Al-Si or the like.

After the upper electrode 17, the connection line 31c and the upper electrode pad 32c are formed, an elastic film 20 made of a resin material is formed on all the first surface side of the silicon substrate 25 by a spin coat method and a photolithography technique. Thereby, the structure shown in FIG. 5G is obtained.

Following the elastic film forming process, a substrate manufacturing process is performed by forming a frame section 11, a weight section 12 and a flexure section 13 through a photolithography technique, an etching technique and the like, thereby obtaining the structure shown in FIG. 5H. In the substrate manufacturing process, a back groove forming process for forming a back groove is performed by etching the silicon substrate 25 up to reaching the silicon dioxide film 36 from the second surface side to remove a part except the frame section 11 and the weight section 12 through a photolithography technique and an etching technique. The silicon dioxide film 36 is then etched to be pierced, so that the frame section 11, the weight section 12 and the flexure section 13 are formed. In this instance, the silicon dioxide film 37 is removed by etching as well. By performing the etching process, the vibration power generation device shown in FIG. 5H is obtained.

In the back groove forming process of the substrate manufacturing process in the embodiment, the silicon substrate 25 is etched through an induction coupled plasma (ICP) type of etching equipment capable of vertical deep etching, and accordingly an angle between a back side of the silicon dioxide film 36 and an inner circumferential face of the frame section 11 can be made about 90°. However, the back groove forming process of the substrate manufacturing process is not limited to dry etching through the ICP type of dry-etching equipment. As long as high anisotropic etching is possible, another dry-etching equipment may be used. In case the first surface of the silicon substrate 25 is a (110) surface, wet etching (crystal anisotropy etching) using a alkaline solution such as a TMAH solution or a KOH solution may be used.

In the vibration power generation device of the embodiment, processes until the substrate manufacturing process has been finished are performed in units of wafers, and a dicing process is then performed, each of which is thereby divided into individual power generation devices.

In the embodiment, the first and second cover substrates 29 and 30 are provided, and accordingly after the etching process for forming the flexure section 13, a cover joining process for joining each of the cover substrates 29 and 30 is performed. In this instance, processes until the cover joining process has been finished are performed in units of wafers, and a dicing process is then performed, each of which is thereby divided into individual power generation devices. What is needed here is to form each of the cover substrates 29 and 30 by arbitrarily applying a known process such as a photolithography process, an etching process, a thin-film formation process, a plating process or the like.

In the power generation section 18, the piezoelectric layer 16 is formed on the lower electrode 15, but the crystallinity of the piezoelectric layer 16 may be further improved by making a buffer layer (not shown), as a foundations when the piezoelectric layer 16 is formed, intervene between the lower electrode 15 and the piezoelectric layer 16. A type of conductive oxide material such as SrRuO₃, (Pb, Ra)TiO₃, PbTiO₃ or the like may be employed as a buffer layer material.

The vibration power generation device may be, for example, an arrayed vibration power generation devices which are arranged in two-dimensional array.

Therefore, in the vibration power generation device of the embodiment, the frame section 11 and the weight section 12 are formed of the silicon substrate 25. The power generation section 18 is provided, on its own surface, with the elastic film 20 made of a resin material. The flexure section 13 comprises the elastic film 20 formed of a resin material having a Young's modulus smaller than that of the silicon forming the frame section 11 and the weight section 12. Thereby, the power generation device can obtain a large output in response to an external vibration having a comparatively low accelerated velocity, and can prevent, through the elastic film 20, breakages of the flexure section 13 due to a vibration of the weight section 12.

In the vibration power generation device of the embodiment, the elastic film 20 is formed up to the weight section 12. Thereby, a larger output can be obtained by increasing the mass of the weight section 12 while preventing breakages of the flexure section 13 due to a vibration of the weight section 12.

In the vibration power generation device, the method of making the vibration power generation device in the embodiment, the frame section 11 and the weight section 12 are formed of a silicon substrate formed with an etching stop layer, and the flexure section 13 is formed by etching the silicon substrate 25 up to reaching the etching stop layer. Thereby, a comparative inexpensive silicon can be used, and accordingly the vibration power generation device can be produced without complicated process.

Although the present invention has been described with reference to certain preferred embodiments, numerous modifications and variations can be made by those skilled in the art without departing from the true spirit and scope of this invention, namely claims.

## Claims

1. A vibration power generation device, comprising:
a frame section;
a weight section located inside the frame section;
a flexure section that is joined between the frame section and the weight section and is configured to bend in response to a displacement of the weight section; and
a power generation section that is located at least at the flexure section and configured to generate an alternating-current voltage in response to a vibration of the weight section,
wherein the frame section and the weight section are formed of a silicon substrate,
wherein the power generation section comprises, at its own surface, an elastic film formed of a resin material,
wherein the flexure section comprises the elastic film formed of the resin material having a Young's modulus smaller than that of silicon forming the frame section and the weight section.

2. The vibration power generation device of claim 1, wherein the flexure section consists of at least only the elastic film, or of the elastic film and an etching stop layer with respect to the silicon substrate, and is provided with the power generation section.

3. The vibration power generation device of claim 1 or 2, wherein the elastic film is formed and extended up to the weight section.

4. A method of making said vibration power generation device of any one of claims 1-3,
wherein the frame section and the weight section are formed of a silicon substrate formed with an etching stop layer, and
wherein the flexure section is formed by etching the silicon substrate up to reaching the etching stop layer.
